# EUROPEAN PATENT APPLICATION

(11) **EP 4 779 260 A1**
(43) Date of publication of application: **22.07.2026**
(21) Application number: 25226234.0
(22) Date of filing: 22.12.2025
(51) Int. Cl.: G01B 11/06, G03F 9/00

(54) **HEIGHT MEASUREMENT DEVICE, EXPOSURE APPARATUS, AND ARTICLE MANUFACTURING METHOD**

(30) Priority: 15.01.2025 JP 2025005645
(71) Applicant: Canon Kabushiki Kaisha, Tokyo, 146-8501 (JP)
(72) Inventor: FUNABASHI, Naoki, Tokyo 146-8501 (JP); ENDO, Yusuke, Tokyo 146-8501 (JP); NARIMATSU, Mizuki, Tokyo 146-8501 (JP); KOYA, Shigeo, Tokyo 146-8501 (JP); MORIKUNI, Yuichiro, Tokyo 146-8501 (JP); UCHIYAMA, Shinzo, Tokyo 146-8501 (JP)
(74) Representative: TBK

(57) **Abstract**

A height measurement device includes an optical measurement device configured to measure a height of a substrate, an air sensor configured to measure a height of the substrate while discharging air through a pipeline based on a pressure in the pipeline, a member having a reference surface, and a controller configured to correct a result obtained by measuring a height at a second measurement location on the substrate using the optical measurement device based on a first result obtained by measuring a height at a first measurement location on the substrate and a height of the reference surface using the optical measurement device and a second result obtained by measuring a height at the first measurement location on the substrate and a height of the reference surface using the air sensor.

## Description

### BACKGROUND

### Field of the Technology

The present disclosure relates to a height measurement device, an exposure apparatus, and an article manufacturing method.

### Description of the Related Art

Japanese Patent Laid-Open No. 2010-109378 discloses a lithography projection apparatus including a first sensor as a process-independent sensor such as an air micrometer and a second sensor as a process-dependent sensor. The measurement value obtained by the second sensor has an offset error (PDOE) that can be dependent on a process. The lithography projection apparatus can execute lithography processing at a plurality of positions on a substrate by scanning the substrate immediately below the first and second sensors. Using the measurement values obtained by the first and second sensors can prepare a map storing a PDOE of the second sensor at each position on the substrate at which measurement has been performed. Since the measurement speed of the first sensor as a process-independent sensor is low, if measurement is executed at a plurality of positions on a substrate by scanning the substrate immediately below the first and second sensors, it takes a considerably long time to perform measurement.

### SUMMARY

The present disclosure provides a technique advantageous in measuring the height of a substrate in a short time with high accuracy by using an optical measurement device and an air sensor.

The present disclosure in its first aspect provides a height measurement device as specified in claim 1. Optional features are specified in claim 2 to 15.

The present disclosure in its second aspect provides an exposure apparatus as specified in claim 16. Optional features are specified in claim 17 to 20.

The present disclosure in its third aspect provides an article manufacturing method as specified in claim 21.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Fig. 1A is a view schematically showing the arrangement of an exposure apparatus according to one embodiment which incorporates a height measurement device according to one embodiment;
Fig. 1B is a view schematically showing the arrangement of the exposure apparatus according to one embodiment which incorporates the height measurement device according to the embodiment;
Fig. 1C is a view schematically showing the arrangement of the exposure apparatus according to one embodiment which incorporates the height measurement device according to the embodiment;
Fig. 2 is a view schematically showing a top view of a substrate stage;
Fig. 3A is a view schematically showing an arrangement example of an air sensor;
Fig. 3B is a view schematically showing another arrangement example of the air sensor;
Fig. 4 is a flowchart showing a procedure of a height measurement method in the exposure apparatus or the height measurement device;
Fig. 5 is a view for explaining measurement deception by an optical measurement device; and
Figs. 6A and 6B are views for explaining Example 1 and Example 2.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

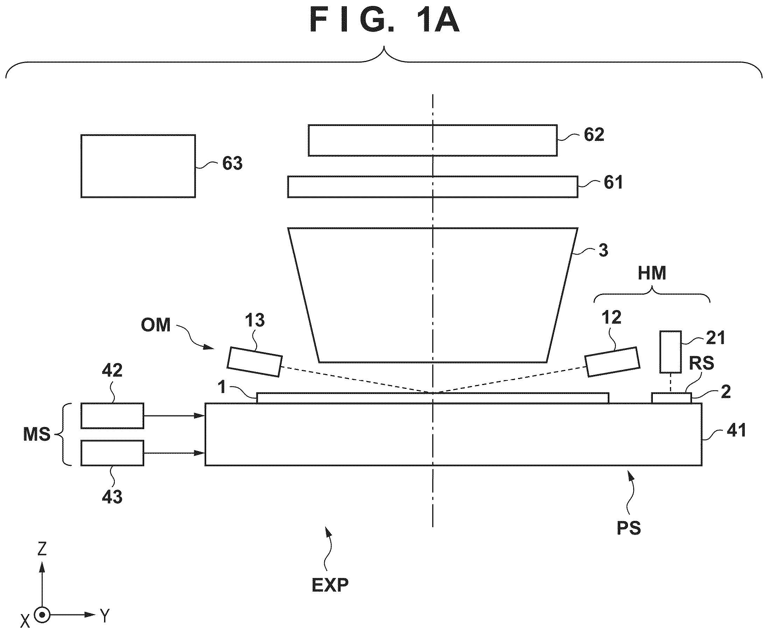

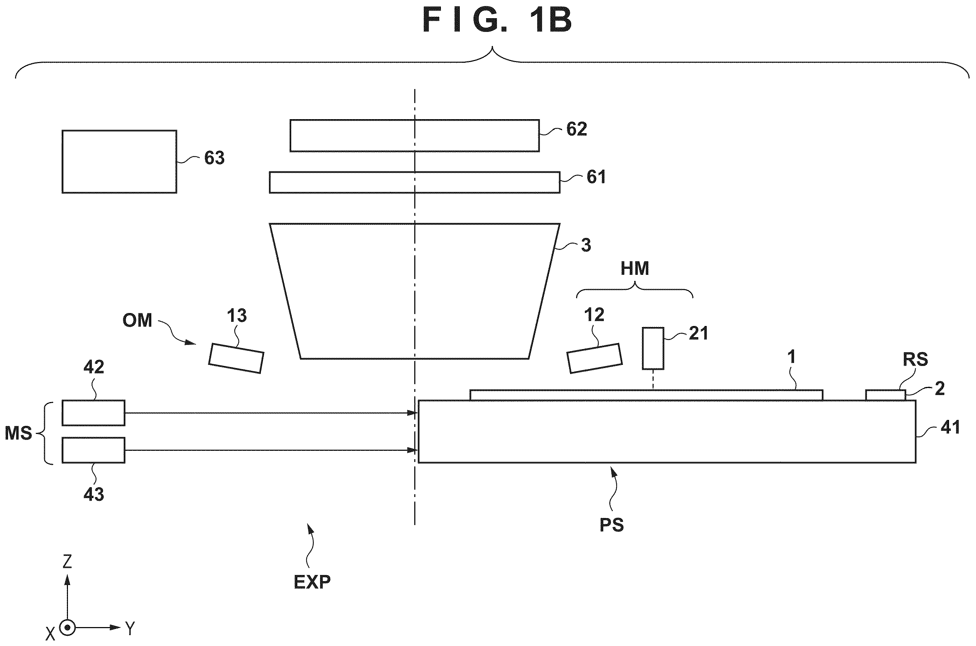

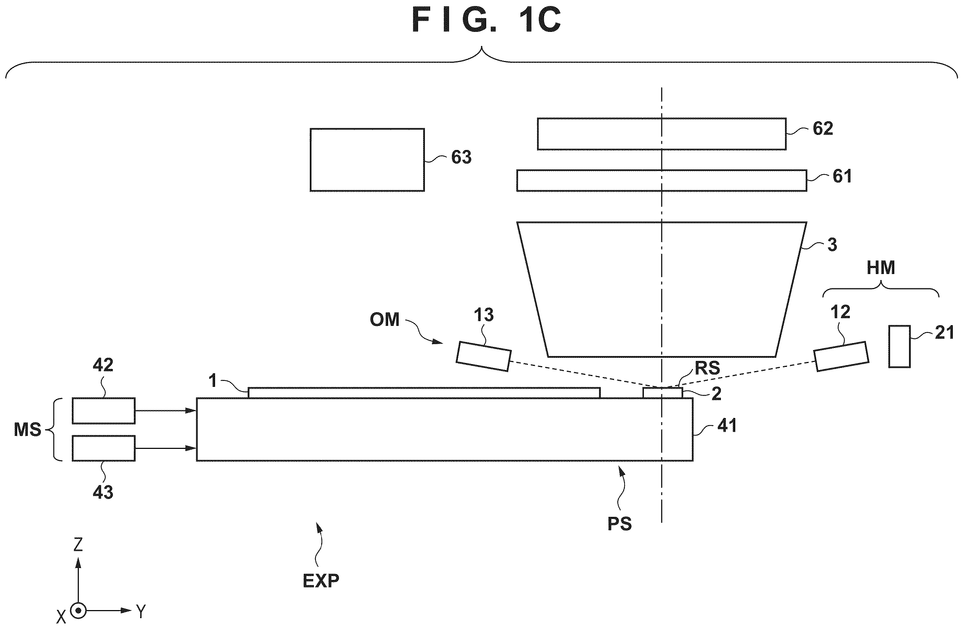

Figs. 1A, 1B, and 1C schematically show the arrangement of an exposure apparatus EXP according to one embodiment which incorporates a measurement device HM according to one embodiment. The exposure apparatus EXP can include an illumination optical system 62 that illuminates an original plate 61 and a projection optical system 3 that projects a pattern of the original plate 61 onto a substrate 1. The exposure apparatus EXP can be configured to perform exposure on the substrate 1 by causing the projection optical system 3 to project the pattern of the original plate 61 onto the substrate 1. The exposure apparatus EXP can include a positioning system PS including a substrate stage 41 that holds the substrate 1 and a height measurement device HM that measures the height of the substrate 1. The positioning system PS can include a stage measurement system MS that measures the position and posture of the substrate stage 41 and control the position and posture of the substrate stage 41 based on an output from the stage measurement system MS. The stage measurement system MS can include, for example, a plurality of measurement devices including measurement devices 42 and 43. The stage measurement system MS can measure the substrate stage 41 concerning six axes by using the plurality of measurement devices. The positioning system PS can control the substrate stage 41 concerning the six axes based on an output from the stage measurement system MS. The plurality of measurement devices may include, for example, a plurality of interferometers or a plurality of encoders or may include one or a plurality of interferometers or one or a plurality of encoders.

The exposure apparatus EXP or the height measurement device HM can include an optical measurement device OM that measures the height of the substrate 1 and an air sensor 21 that measures the height of the substrate 1. The optical measurement device OM may be an oblique-incidence measurement device that irradiates a measurement target surface with light and receives reflected light from the measurement target surface and can include a light projector 12 that projects patterned light onto a measurement target surface and a light receiver 13 that receives reflected light from the measurement target surface. As will be described later, in the optical measurement device OM, since light is reflected by an internal structure of the substrate 1 (a structure existing below the uppermost surface) in addition to the uppermost surface of the substrate 1, a measurement error can occur depending on the internal structure of the substrate 1. The air sensor 21 can also be called an air microsensor. The air sensor 21 can be configured to be able to measure the height of the substrate 1 with a resolution of nanometer order or 1 nm or higher. The air sensor 21 can be configured to measure the height of the substrate 1 based on the pressure of a pipeline while discharging air through the pipeline. As will be described later, the measurement result obtained by the air sensor 21 is unaffected by the internal structure of the substrate 1.

The exposure apparatus EXP or the height measurement device HM can include a reference plate 2 as the position of a member having a reference surface RS and a controller 63. The reference plate 2 has, for example, a reference mark whose position is detected by an alignment sensor (not shown) and can be placed on the substrate stage 41. The reference surface RS can be a flat surface. The controller 63 is implemented by, for example, a programmable logic device (PLD) such as a field programmable gate array (FPGA), an application specific integrated circuit (ASIC), a general-purpose or dedicated computer installed with a program, or a combination of all or some of them. The controller 63 can acquire the first result by measuring a height at a first measurement location on the substrate 1 and the height of the reference surface RS of the reference plate 2 using the optical measurement device OM. The controller 63 can also acquire the second result obtained by measuring a height at the first measurement location on the substrate 1 and the height of the reference surface RS of the reference plate 2 using the air sensor 21. The controller 63 can correct the result obtained by measuring a second measurement location on the substrate 1 using the optical measurement device OM based on the first result and the second result. The controller 63 can generate correction information for the correction of the result obtained by measuring the second measurement location on the substrate 1 using the optical measurement device OM based on the first result and the second result. The controller 63 can generate, for example, correction information based on the difference between the first result and the second result. The controller 63 can obtain, in a short time with high accuracy, height information of the second measurement location by correcting the result obtained by measuring a height at the second measurement location on the substrate 1 using the optical measurement device OM based on correction information.

The first result can be the difference between the result obtained by measuring a height at the first measurement location (for example, a specific location in a shot region) on the substrate 1 using the optical measurement device OM and the result obtained by measuring the height of the reference surface RS using the optical measurement device OM. Alternatively, the first result can be the difference between the average of the results obtained by measuring heights at a plurality of first measurement locations (for example, a plurality of specific locations in a shot region) on the substrate 1 using the optical measurement device OM and the result obtained by measuring the height of the reference surface RS using the optical measurement device OM.

The second result can be the difference between the result obtained by measuring a height at the first measurement location (for example, a specific location in a shot region) on the substrate 1 using the air sensor 21 and the result obtained by measuring the height of the reference surface RS using the air sensor 21. Alternatively, the second result can be the difference between the average of the results obtained by measuring heights at a plurality of first measurement locations (for example, a plurality of specific locations in a shot region) on the substrate 1 using the air sensor 21 and the result obtained by measuring the height of the reference surface RS using the air sensor 21.

Fig. 1A schematically shows how a height at the first measurement location on the substrate 1 is measured by the optical measurement device OM and how the height of the reference surface RS is measured by using the air sensor 21. Fig. 1B schematically shows how a height at the first measurement location on the substrate 1 is measured by using the air sensor 21. Fig. 1C schematically shows how the height of the reference surface RS is measured by the optical measurement device OM.

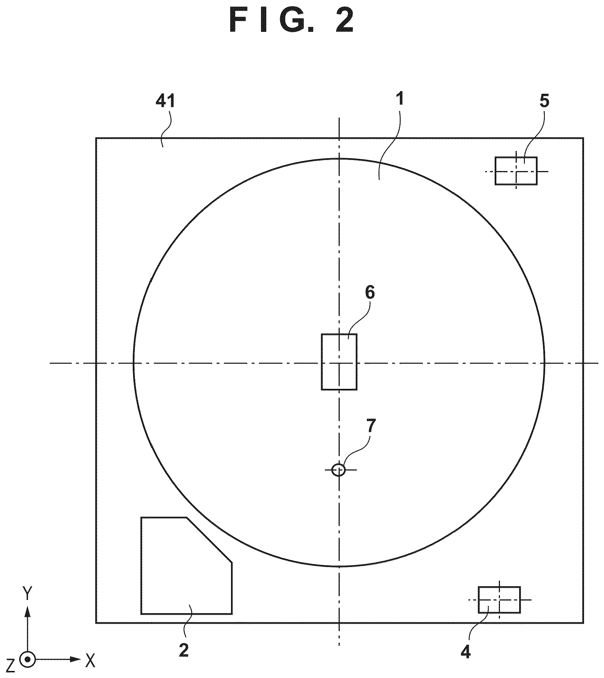

Fig. 2 schematically shows a top view of the substrate stage 41. Additional reference plates 4 and 5 may be arranged on the substrate stage 41. The reference plates 4 and 5 can have reference marks. The thermal deformation of the top plate of the substrate stage 41 can be evaluated by measuring the positions of the respective reference marks of the reference plates 2, 4, and 5 using an off-axis scope (not shown).

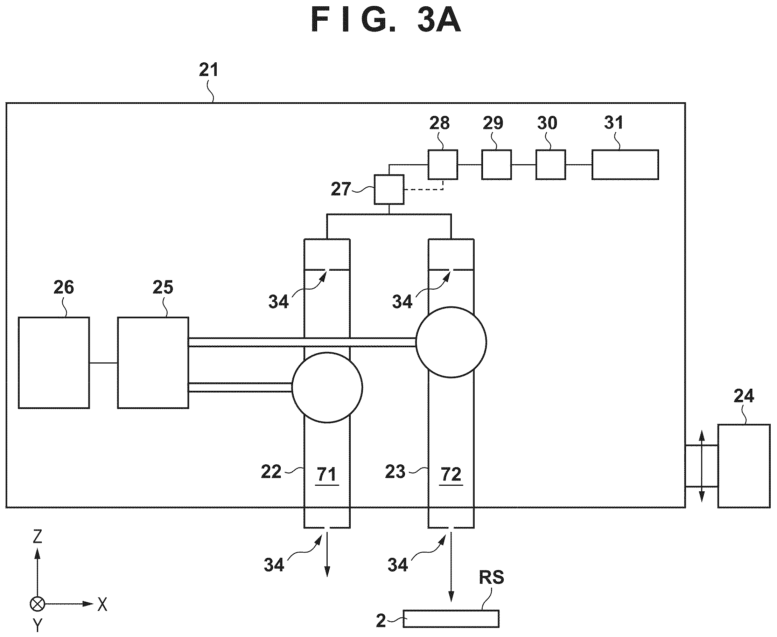

Fig. 3A schematically shows an arrangement example of the air sensor 21. The air sensor 21 can include a reference nozzle 22 that discharges air through a first pipeline 71, a measurement nozzle 23 that discharges air through a second pipeline 72, and a differential pressure sensor 25 that detects the difference between the pressure in the first pipeline 71 and the pressure in the second pipeline 72. The air sensor 21 may further include a mass flow controller 28 and can supply air to the reference nozzle 22 and the measurement nozzle 23 through the mass flow controller 28. An air supply source 31 can supply air to the mass flow controller 28. A filter 29 and a valve 30 can be arranged between the mass flow controller 28 and the air supply source 31. The exposure apparatus EXP or the height measurement device HM can include a driving mechanism (for example, an elevating mechanism) 24 that moves the air sensor 21. The mass flow controller 28 can supply air to the reference nozzle 22 and the measurement nozzle 23 through a sensor 27 such as a pressure gauge or flowmeter. The air sensor 21 may further include a processor 26. The processor 26 can convert an output from the differential pressure sensor 25 into height information. The reference nozzle 22 and the measurement nozzle 23 each can be provided with orifices 34 at the inlet and the outlet.

The mass flow controller 28 supplies air whose pressure and flow rate are constantly regulated to the reference nozzle 22 and the measurement nozzle 23. The mass flow controller 28 can operate so as to maintain the pressure on the outlet side of the mass flow controller 28 to a predetermined pressure (for example, 70 kPa ± 0.01 kPa) based on the output from the sensor 27. The diameter of each orifice 34 may fall within, for example, the range of 0.1 mm to 0.2 mm. Since the orifice 34 operates as a resistance to the flow of air, the pressure in the first pipeline 71 of the reference nozzle 22 can be kept constant. The pressure in the second pipeline 72 of the measurement nozzle 23 becomes a value corresponding to the distance between the measurement nozzle 23 and a measurement target surface, and the pressure in the first pipeline 71 of the reference nozzle 22 and the pressure in the second pipeline 72 of the measurement nozzle 23 are supplied to the differential pressure sensor 25. Accordingly, a differential pressure corresponding to the distance between the measurement nozzle 23 and the measurement target surface is supplied to the differential pressure sensor 25. The air sensor 21 is free from any measurement error due to an internal structure existing below a measurement target surface.

The output voltage of the differential pressure sensor 25 can depend on the diameter of the orifice 34. As the diameter of the orifice 34 increases, the measurement resolution increases. On the other hand, the working distance increases, and the time required to measure becomes shorter. In contrast to this, as the diameter of the orifice 34 decreases, the measurement resolution decreases. On the other hand, the working distance decreases, and the time required to measure increases. When, for example, the height of the reference surface RS changes by 1 nm, the diameter of the orifice 34 can be determined so as to change the output voltage of the differential pressure sensor 25 by 2 mV. At this time, the working distance is, for example, 35 micrometers.

The controller 63 can calibrate the air sensor 21 based on an output from the air sensor 21 when the positioning system PS changes the height of the substrate stage 41 by a predetermined height. The calibration of the air sensor 21 can include causing the processor 26 to update the conversion formula for converting the output voltage of the differential pressure sensor 25 into a height. The controller 63 may calibrate the air sensor 21 based on a change in output from the differential pressure sensor 25 when causing the positioning system PS to change the height of the substrate stage 41 by increments (for example, an increase or decrease by increments of 1 nm). In general, the conversion formula is nonlinear. The conversion formula may include a time drift component and/or a temperature-dependent component. The base of a reference plate is formed of a metal or ceramic material having a small thermal expansion coefficient, and a reference mark can be formed of silica glass.

The controller 63 can calibrate the air sensor 21 such that the result obtained by measuring the height of the reference surface RS of the reference plate 2 using the air sensor 21 becomes 0. Alternatively, the controller 63 may obtain a corrected measurement value by holding, as a reference value, the result obtained by measuring the height of the reference surface RS of the reference plate 2 using the air sensor 21 and subtracting a reference value from the measurement value obtained by measuring a height at a measurement location using the air sensor 21. In this case, the calibration includes the operation of holding the reference value. Likewise, the controller 63 can calibrate the optical measurement device OM such that the result obtained by measuring the height of the reference surface RS of the reference plate 2 using the optical measurement device OM becomes 0. Alternatively, the controller 63 may obtain a corrected measurement value by holding, as a reference value, the result obtained by measuring the height of the reference surface RS of the reference plate 2 using the optical measurement device OM and subtracting the reference value from the measurement value obtained by measuring a height at a measurement location using the optical measurement device OM. In this case, the calibration includes the operation of holding the reference value.

Since the drift of the air sensor 21 is considerably large, the air sensor 21 can be calibrated as frequently as, for example, every nine seconds.

For example, after the air sensor 21 and the optical measurement device OM each are calibrated by using the reference surface RS of the reference plate 2, a height at the first measurement location on the substrate 1 is measured by the air sensor 21 and the optical measurement device OM. If the difference between the results obtained by measuring the height at the first measurement location on the substrate 1 using the air sensor 21 and the optical measurement device OM is equal to or more than a predetermined value (for example, 10 nm), the controller 63 can update or generate correction information. The controller 63 can update or generate correction information so as to match the measurement result obtained by the optical measurement device OM with the measurement result obtained by the air sensor 21.

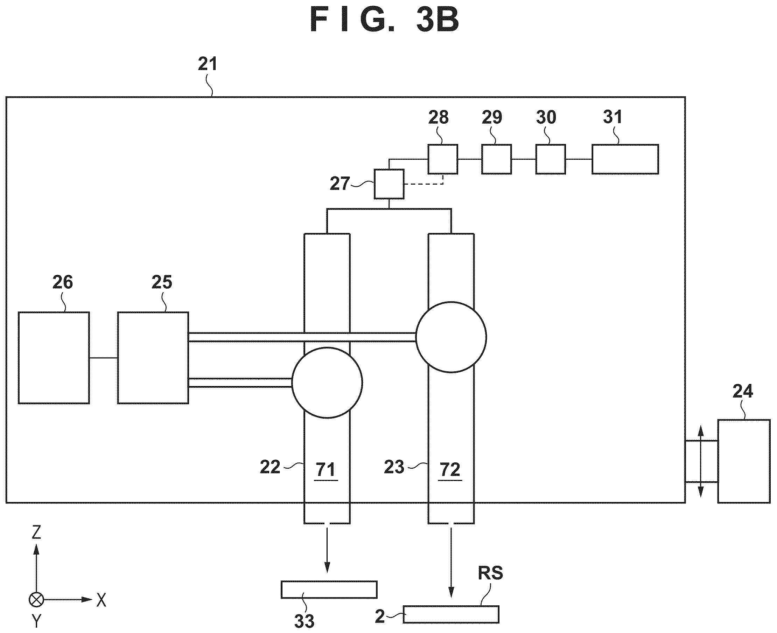

Fig. 3B schematically shows another arrangement example of the air sensor 21. In the arrangement example shown in Fig. 3B, a sensor reference surface 33 is provided to face the reference nozzle 22.

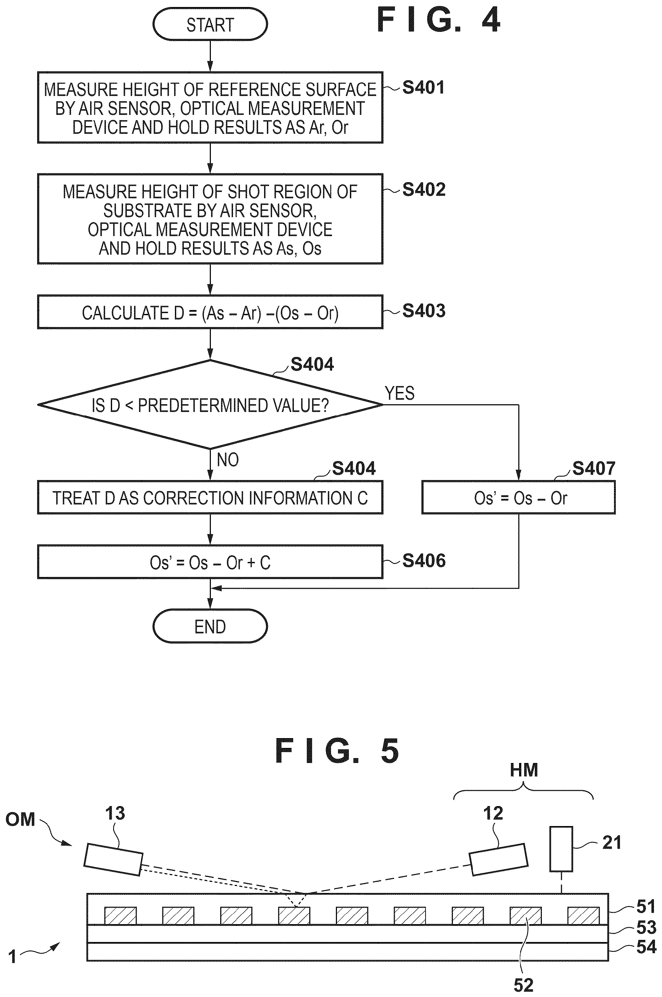

Fig. 4 is a flowchart showing a procedure of a height measurement method in the exposure apparatus EXP or the height measurement device HM. This height measurement method can be controlled by the controller 63 and executed, for example, at the head of a lot or recipe. For example, the working distance of the air sensor 21 can be limited to about several ten micrometers to implement a resolution at several nm level. Resolution and working distance have a tradeoff relationship. In a case where the substrate stage 41 is moved along an XY plane, in order to adjust the running error of the substrate stage 41 or the inclination of the substrate 1 at the time of exposure, it is necessary to drive the substrate stage 41 concerning the Z direction, TiltX, and TiltY. In order to prevent the substrate stage 41 from striking the distal ends of the reference nozzle 22 and the measurement nozzle 23 of the air sensor 21, it is preferable to retract the air sensor 21 by using the driving mechanism 24 upon completion of measurement by the air sensor 21. The driving mechanism 24 can include, for example, an elevating mechanism and/or a horizontal driving mechanism. In a case where the air sensor 21 performs measurement, it is necessary to move the air sensor 21 from the retraction position to the measurement position by using the driving mechanism 24 and to wait until the air sensor 21 is settled.

Referring to Fig. 4, in step S401, the controller 63 causes the air sensor 21 and the optical measurement device OM to measure a predetermined region (a region without any reference mark) on a flat surface of the reference plate 2 on the substrate stage 41 and holds the measurement results as Ar and Or. In this case, the air sensor 21 and the optical measurement device OM may be calibrated (subjected to teaching) such that the respective measurement results become 0. In this measurement, the positioning system PS positions the substrate stage 41 concerning X, Y, Z, θX, θY, and θZ based on outputs from the stage measurement system MS. Note that θX, θY, and θZ respectively represent rotation about the X-axis, rotation about the Y-axis, and rotation about the Z-axis. A region where the air sensor 21 performs measurement is generally different from a region where the optical measurement device OM performs measurement. Accordingly, the position of the substrate stage 41 at the time of measurement of a predetermined region on the reference plate 2 by the air sensor 21 is different from the position of the substrate stage 41 at the time of measurement of a predetermined region on the reference plate 2 by the optical measurement device OM. The positioning system PS has positioning accuracy (for example, a resolution of 0.1 nm or less) high enough to enable the air sensor 21 and the optical measurement device OM to measure the same region (predetermined region) of the reference plate 2.

In step S402, the controller 63 causes each of the air sensor 21 and the optical measurement device OM to measure the first measurement location on a shot region on the substrate 1 coated with a resist on the substrate stage 41 and holds the measurement results as As and Os, respectively. In this case, the controller 63 may hold, as As, the average value of the results obtained by measuring a plurality of first measurement locations on a shot region on the substrate 1 coated with a resist on the substrate stage 41 by using the air sensor 21. Alternatively, the controller 63 may hold, as Os, the average value of the results obtained by measuring a plurality of first measurement locations on a shot region on the substrate 1 coated with a resist on the substrate stage 41 by using the optical measurement device OM. The X- and Y-coordinates of a plurality of first measurement locations measured by the air sensor 21 are the same as those of a plurality of first measurement locations measured by the optical measurement device OM.

In step S403, the controller 63 calculates D = (As - Ar) - (Os - Or). In this case, (Os - Or) represents the first result obtained by measuring the height at the first measurement location on the substrate 1 and the height of the reference surface RS of the reference plate 2 using the optical measurement device OM. (As - Ar) represents the second result obtained by measuring the height at the first measurement location on the substrate 1 and the height of the reference surface RS of the reference plate 2 using the air sensor 21. D represents the difference between the first result and the second result and can be understood as a measurement error (measurement deception amount) of the optical measurement device OM due to the internal structure of the substrate 1.

In step S404, the controller 63 determines whether D (measurement deception amount) is smaller than a predetermined value (allowable value). If D (measurement deception amount) is smaller than the predetermined value (allowable value), the process advances to step S407. If D is equal to or more than the predetermined value, the process advances to step S405. In step S406, the controller 63 determines D (measurement deception amount) as correction information C. In step S406, the controller 63 calculates Os' = Os - Or + C as the measurement result obtained by the optical measurement device OM. This indicates that the result obtained by calibrating the measurement result at the first measurement location on the substrate 1 using the optical measurement device OM based on the measurement result on the reference surface RS using the optical measurement device OM is corrected based on the correction information C. In a case where subsequent shot regions (the second measurement locations) of the lot are measured, the controller 63 calculates Os' = Os - Or + C as the measurement result obtained by the optical measurement device OM. In step S407, the controller 63 obtains Os' = Os - Or as the measurement result of the height of the shot region.

Consider a specific case where five first measurement locations are set in a shot region. Assume that the average of the results obtained by measuring heights at the five measurement locations using the optical measurement device OM as Os = 20 nm, and the average of the results obtained by measuring heights at the five first measurement locations using the air sensor 21 as As = 50 nm. In addition, assume that a predetermined value (allowable value) is 10 nm. For the sake of simplicity, assume that Or = 0 and Ar = 0. In this case, the deception amount D is (50 nm - 0 nm) - (20 nm - 0 nm) = 30 nm. Since D = 30 nm > allowable value (10 nm), the correction information C is 30 nm.

Determining correction information for the correction of the measurement result obtained by the optical measurement device OM in the above manner makes it possible to measure heights concerning subsequent shot regions and subsequent substrates 1 in a short time with high accuracy by using the optical measurement device OM.

Measurement deception by the optical measurement device OM will be described below with reference to Fig. 5. The substrate 1 can include, for example, a plurality of layers 52, 53, and 54 on a base material (not shown) made of a semiconductor and a resist 51 constituting the uppermost layer. On the sub-micrometer level, the uppermost surface of the substrate 1 before being coated with a resist has unevenness, and the uppermost surface (that is, the resist 51) of the substrate 1 after being coated with the resist 51 also has unevenness.

In the exposure apparatus EXP, the position of the uppermost surface of the resist 51 with which the imaging plane of the projection optical system 3 of the entire substrate 1 should be matched should be measured by the optical measurement device OM. In the optical measurement device OM, part of light projected onto the substrate 1 by the light projector 12 can reach at least one of the plurality of layers 52, 53, and 54 under the resist 51 through the resist 51. The light reflected by at least one of the plurality of layers 52, 53, and 54 can enter the light receiver 13. When both the light reflected by the uppermost surface of the substrate 1 and the light reflected by the layers under the uppermost layer enter the light receiver 13, this may cause measurement deception. Note that if the plurality of layers 52, 53, and 54 are flat and the thickness and refractive index of the resist 51 are known, a measurement deception amount may be calculated. In practice, however, since the surfaces of the plurality of layers 52, 53, and 54 and the resist 51 are not flat, the calculation of a measurement deception is unrealistic.

### (Example 1)

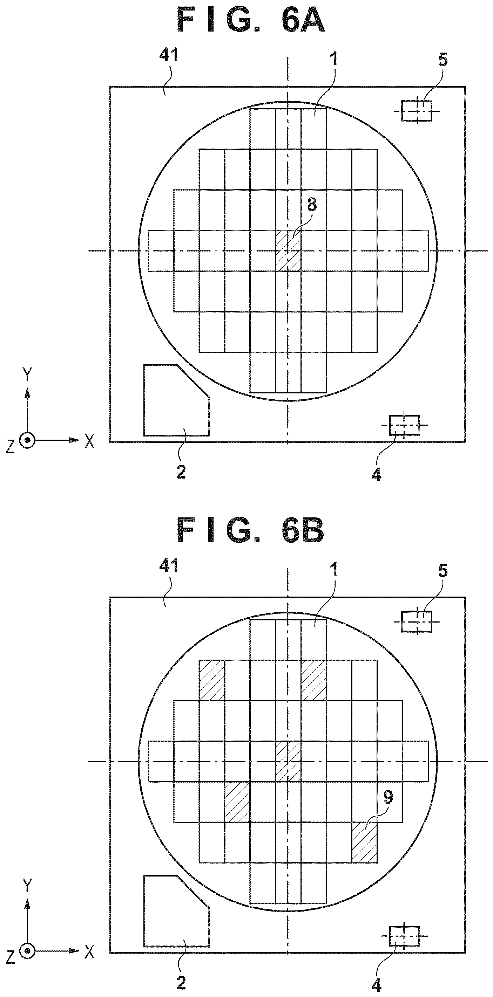

Fig. 6A exemplarily shows the layout of a plurality of shot regions on a substrate 1. In the case shown in Fig. 6A, the shot region whose height is measured by an air sensor 21 is a shot region 8 placed in the center. Assume that the heights of all the shot regions on the substrate 1 are measured by the air sensor 21. In this case, since measurement at one measurement location requires 300 msec, it requires a very long time for the measurement. Since the measurement time at one measurement location by an optical measurement device OM is, for example, about 10 msec, performing measurement using the optical measurement device OM will greatly increase the throughput as compared with the case where measurement is performed by the air sensor 21. For this reason, it is desirable to perform measurement without using the air sensor 21 as far as possible.

For example, a plurality of shot regions each having a size of 26 mm x 33 mm can be arranged on the substrate 1. A height distribution is common among a plurality of shot regions. It is possible to measure heights at a plurality of measurement locations in only one shot region and calculate the average of the heights at the plurality of measurement locations by using the air sensor 21. A plurality of measurement locations can be set so as to represent an internal structure. For example, 5 x 6 = 30 measurement locations are defined at equal intervals in one shot region, and the heights at these measurement locations are measured by both the air sensor 21 and the optical measurement device OM. Although the air sensor 21 needs to sequentially measure the heights at 30 measurement locations, the optical measurement device OM can simultaneously measure the heights at 30 measurement locations. In order to measure the heights at 30 measurement locations, the air sensor 21 requires 30 x 300 msec = 9000 msec = 9 s. In contrast to this, the optical measurement device OM can simultaneously measure the heights at the 30 measurement locations and hence requires only 10 msec. Assume that the number of shot regions on the substrate 1 is 64. In this case, it takes 9000 msec x 64 = 576000 msec = 576 s = about 10 min for the air sensor 21 to measure the heights at all the measurement locations In contrast to this, it takes only 10 msec x 64 = 640 msec = 0.64 s for the optical measurement device OM to measure the heights at all the measurement locations. Note that this calculation does not include the step driving time (several ten msec per step) for the step movement of measurement locations in a measurement region of the air sensor 21, and hence it takes a longer time for the air sensor 21 to measure the heights at all the measurement locations. As the measurement time increases, the air sensor 21 drifts. Accordingly, if calibration is performed by using the reference surface RS every time, for example, heights at 30 measurement locations are measured (every 9 s), it requires a longer time.

In the case of an exposure apparatus with a throughput of 300 WPH (a production of 7200 substrates per day), since five substrates are exposed per minute, measuring over 10 min will reduce the productivity by about 50 substrates. For example, in a case where 10 types of devices are manufactured per day, a daily productivity of 500 substrates (corresponding to a loss of 7%) will be sacrificed. Accordingly, measuring the heights of all the shot regions on a substrate with the air sensor 21 will considerably reduce the productivity.

In the present embodiment, after correction information C is obtained by using the air sensor and the optical measurement device, the result obtained by measuring a height at the second measurement location using the optical measurement device is corrected based on the correction information C, thus obtaining height information about the second measurement location in a short time with high accuracy.

The operation of measuring a height at the first measurement location using the air sensor is preferably performed for every lot (for example, 25 substrates) in order to maintain the exposure accuracy high. However, after a height at the first measurement location is measured by using the air sensor, it is necessary to retract the air sensor from the measurement position to the retraction position before an exposure operation is performed. In order to measure a height at the first measurement location by using the air sensor, it is necessary to move the air sensor from the retraction position to the measurement position. Because such an operation becomes a factor that reduces the productivity, a height at the first measurement location may be measured by using the air sensor for every few lots when productivity is prioritized.

In order to stabilize the position of the air sensor, a lock mechanism may be provided, which fixes the position of the air sensor after the air sensor is driven to the measurement position.

In addition, since the measurement value of the air sensor tends to drift, it is desirable to periodically calibrate the air sensor. In a case where the type of substrate to be processed is changed, since the internal structure and the resist film thickness change, it is desirable to calibrate the optical measurement device by using the air sensor. It is desirable to calibrate the optical measurement device by using the air sensor for every lot. However, in a case where the same recipe is repeatedly used, the optical measurement device may be calibrated by using the air sensor for every few lots.

In a conventional method using no air sensor, in a case where exposure is to be performed on substrates that differ in internal structure but have the same resist surface height, it has been necessary to check best focus by performing pilot production (test production) so as to check the correct height offset value of the exposure apparatus.

Calibrating the optical measurement device by using the air sensor can accurately obtain the height information of substrates by using the optical measurement device even with different internal structures. This makes it possible to save the trouble of performing pilot production. In this pilot production, at least one lot (25) of substrates is prepared, and exposure is performed to develop the substrates. The developed substrates are then examined with an electron microscope to calculate best focus. Accordingly, it requires an adjustment time of a few hours per recipe. In addition, it is possible to save the trouble of performing rework on substrates of one lot.

### (Example 2)

In Example 1, the throughput is improved by measuring only one shot region in one substrate using the air sensor. However, if, for example, there is resist film thickness unevenness within a surface of a substrate, only measuring the height of an arbitrary shot region by using the air sensor may lead to an error that cannot be overlooked. Note that the resist film thickness may be measured by using a general scanning white light interferometer outside the exposure apparatus. A method of correcting the influence of resist film thickness unevenness in the exposure apparatus by using an air sensor will be described below.

Consider a case where 64 shot regions each having a size of 26 mm x 33 mm are arranged on one substrate. For example, measuring a height at one measurement location in each shot using the air sensor makes it possible to measure a global height distribution on a surface of a substrate. Alternatively, in a case where a resist film thickness distribution on a substrate has already been measured with a film thickness gauge in advance outside the exposure apparatus instead of measurement at one point in each shot region, sparse measurement, that is, measuring only representative points (five points in this case) of in-plane film thicknesses in the exposure apparatus. Fig. 6B schematically shows an example of sparse measurement. Referring to Fig. 6B, shot regions 9 indicated by the hatchings are measurement targets.

In a case where one measurement location in each of all the shot regions is calculated by the air sensor 21, it requires 64 x 300 msec = 19200 msec = 19.2 s. However, in a case where only the selected five shot regions are measurement targets, it is possible to shorten the measurement time to 5 x 300 msec = 1500 msec, that is, 1/13. If the measurement time is long, since the air sensor drifts, it is necessary to perform calibration using a reference plate every time, for example, 30 measurement locations are measured (every time 9 s elapse). If measurement using the air sensor is completed, the same measurement location is measured by using the optical measurement device. This makes it possible to collate a global height distribution on a surface of a substrate using the air sensor with the measurement value of the optical measurement device which is obtained by measuring the same point using local height information in one shot region. Using the difference makes it possible to correct the measurement value of the optical measurement device. In sparse sampling, if the number of measurement points in the optical measurement device does not match the number of measurement points in the air sensor, interpolating data by using an approximating method such as polynomial approximation between measurement locations of the air sensor makes it possible to collate with the measurement result obtained by the optical measurement device. This makes it possible to perform accurate correction.

Example 2 has exemplified the case where the present disclosure is characterized in the sparse five measurement points. Naturally, however, in consideration of a preceding resist film thickness distribution map or the characteristics of substrate distortion (unevenness or asymmetrical deformation), sampling places can be freely changed to measurement points that capture the characteristics of the deformation of the substrate. As has been described above, the throughput is improved by avoiding the use of the air sensor as far as possible by minimizing the number of measurement points upon capturing the characteristics of a substrate surface instead of measuring all the shot regions.

An article manufacturing method of manufacturing articles (semiconductor IC elements, liquid crystal display elements, MEMS, and the like) by using the above exposure apparatus will be described next. An article is manufactured using the above exposure apparatus by processing a substrate (a wafer, a glass substrate, or the like) coated with a photosensitive agent in an exposure step of exposing the substrate, a developing step of developing the substrate (photosensitive agent), and other known processing steps of processing the developed substrate. Other known steps include, for example, etching, resist stripping, dicing, bonding, and packaging. This article manufacturing method can manufacture articles with higher quality than conventional articles.

### Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. A height measurement device comprising:
an optical measurement device configured to measure a height of a substrate;
an air sensor configured to measure a height of the substrate while discharging air through a pipeline based on a pressure in the pipeline;
a member having a reference surface; and
a controller configured to correct a result obtained by measuring a height at a second measurement location on the substrate using the optical measurement device based on a first result obtained by measuring a height at a first measurement location on the substrate and a height of the reference surface using the optical measurement device and a second result obtained by measuring a height at the first measurement location on the substrate and a height of the reference surface using the air sensor.

2. The device according to claim 1, wherein the controller generates correction information for correcting a result obtained by measuring a height at the second measurement location using the optical measurement device based on the first result and the second result.

3. The device according to claim 2, wherein the controller generates the correction information based on a difference between the first result and the second result.

4. The device according to claim 3, wherein the first result is a difference between a result obtained by measuring a height at the first measurement location on the substrate using the optical measurement device and a result obtained by measuring a height of the reference surface using the optical measurement device.

5. The device according to claim 3, wherein the first result is a difference between an average of results obtained by measuring heights at a plurality of first measurement locations on the substrate using the optical measurement device and a result obtained by measuring a height of the reference surface using the optical measurement device.

6. The device according to claim 4, wherein the second result is a difference between a result obtained by measuring a height at the first measurement location on the substrate using the air sensor and a result obtained by measuring a height of the reference surface using the air sensor.

7. The device according to claim 5, wherein the second result is a difference between an average of results obtained by measuring heights at a plurality of first measurement locations on the substrate using the air sensor and a result obtained by measuring a height of the reference surface using the air sensor.

8. The device according to any one of claims 1 to 7, wherein the optical measurement device is an oblique-incidence measurement device configured to irradiate a measurement target surface with light and receive reflected light from the measurement target surface.

9. The device according to any one of claims 1 to 8, further comprising a positioning system including a substrate stage configured to hold the substrate,
wherein the member is provided on the substrate stage.

10. The device according to claim 9, wherein the positioning system includes a measurement system configured to measure a position and a posture of the substrate stage and controls a position and a posture of the substrate stage based on an output from the measurement system.

11. The device according to claim 10, wherein the controller calibrates the air sensor based on an output from the air sensor when causing the positioning system to change a height of the substrate stage by a predetermined height.

12. The device according to any one of claims 1 to 11, wherein the air sensor comprises a reference nozzle configured to discharge air through a first pipeline, a measurement nozzle configured to discharge air through a second pipeline, and a differential pressure sensor configured to detect a difference between a pressure in the first pipeline and a pressure in the second pipeline.

13. The device according to claim 12, wherein the air sensor further includes a mass flow controller and supplies air to the reference nozzle and the measurement nozzle through the mass flow controller.

14. The device according to any one of claims 1 to 13, wherein the controller updates the correction information in a case where a difference between the first result and the second result is not less than a predetermined value.

15. The device according to claim 14, wherein the predetermined value is 10 nm.

16. An exposure apparatus that projects a pattern of an original plate onto a substrate by using a projection optical system and exposes the substrate to light, the apparatus comprising:
a positioning system including a substrate stage configured to hold the substrate;
and
a height measurement device configured to measure a height of the substrate held by the substrate stage and defined in any one of claims 1 to 15.

17. The apparatus according to claim 16, wherein the first result is a difference between an average of results obtained by measuring heights at a plurality of first measurement locations in a shot region of the substrate using the optical measurement device and a result obtained by measuring a height of the reference surface using the optical measurement device, and
the second result is a difference between an average of results obtained by measuring heights at the plurality of first measurement locations in the shot region of the substrate using the air sensor and a result obtained by measuring a height of the reference surface using the air sensor.

18. The apparatus according to claim 16 or 17, wherein the optical measurement device is an oblique-incidence measurement device configured to irradiate a measurement target surface with light and receive reflected light from the measurement target surface.

19. The apparatus according to any one of claims 16 to 18, wherein the positioning system includes a measurement system configured to measure a position and a posture of the substrate stage and controls a position and a posture of the substrate stage based on an output from the measurement system.

20. The apparatus according to claim 19, wherein the controller calibrates the air sensor based on an output from the air sensor when causing the positioning system to change a height of the substrate stage by a predetermined height.

21. An article manufacturing method comprising:
exposing a substrate to light by using an exposure apparatus defined in any one of claims 16 to 20;
developing the substrate having undergone the exposing; and
obtaining an article by processing the substrate having undergone the developing.
